# EUROPÄISCHE PATENTSCHRIFT

(11) **EP 2 111 904 B1**
(45) Veröffentlichungstag und Bekanntmachung des Hinweises auf die Patenterteilung: **01.04.2015**
(21) Anmeldenummer: 09010435.7
(22) Anmeldetag: 05.02.2007
(51) Int. Cl.: B01D 46/10, H05K 7/20, F04D 29/64, F04D 29/70

(54) **Filterlüfter mit einer Schnellbefestigungseinrichtung**
Filter fan with a rapid fastening device
Ventilateur a filtre comprenant un dispositif de fixation rapide

(30) Priorität: 13.06.2006 DE 202006009355 U
(43) Veröffentlichungstag der Anmeldung: 28.10.2009
(62) Teilanmeldung aus: 07002402.1
(73) Patentinhaber: Pfannenberg GmbH, 21035 Hamburg (DE)
(72) Erfinder: Pfannenberg, Andreas, 21035 Hamburg (DE)
(74) Vertreter: RGTH

(56) Entgegenhaltungen:
- EP-A- 0 352 113
- EP-A- 1 720 395
- DE-U1-202006 009 355
- US-B1- 6 189 848

## Beschreibung

Die Erfindung betrifft einen Filterlüfter mit einer Schnellbefestigungseinrichtung.

Zur Belüftung von Schaltschränken, elektronischen Steuereinrichtungen und Computern dienen Filterlüfter, die in eine korrespondierende Öffnung in einer Gehäusewand beispielsweise eines Schaltschranks eingesetzt sind. Die Filterlüfter verfügen über ein Gebläse, um Umgebungsluft in das Gehäuse hineinzufördem, wobei das Gehäuse zusätzlich mit Luftaustrittsschlitzen versehen ist. Um eine Verunreinigung der elektronischen Einrichtungen im Gehäuse zu vermeiden, verfügt der Filterlüfter über eine Filtereinrichtung, beispielsweise in Form einer austauschbaren Filtermatte.

Ein derartiger Filterlüfter ist aus der EP 0 439 667 B1 bekannt, wobei der Filterlüfter über ein Grundgehäuse mit einem Rahmen verfügt. An dem Rahmen sind Schnellbefestigungseinrichtungen in Form von federelastischen Laschen ausgebildet, um den Filterlüfter ohne zusätzliche Schrauben oder sonstige Montagemittel werkzeuglos in eine Gehäuseöffnung einsetzen und dort mit Hilfe der federelastischen Laschen verrasten zu können.

Des weiteren ist nach der DE 20 2006 009 355.9 ein Filterlüfter mit einem Grundgehäuse mit einem Rahmen bekannt, wobei der Rahmen mit Schnellbefestigungseinrichtungen in Form von federelastischen bevorzugterweise flügelartigen Laschen versehen ist. Der Rahmen ist um seinen Umfang durchgehend umlaufend geschlossen ausgebildet, wobei die Laschen an den Rahmen angeformt sind. Bei diesem Filterlüfter sind die Schnellbefestigungseinrichtungen in Form federelastischen Laschen nicht aus einem Abschnitt einer Seitenwand bzw. eines Rahmens des Grundgehäuses des Filterlüfters ausgeschnitten, sondern außenseitig an diesem Rahmen bzw. den Seitenwänden angeformt. Der Filterlüfter bzw. dessen Grundgehäuse besteht aus einem Kunststoff-Spritzgussteil, so dass bei der Herstellung des Rahmens bereits die zusätzlichen Laschen einstückig mit dem Rahmen an diesem angeformt oder ausgebildet werden können. Die Laschen sind dabei quasi außenseitig am Rahmen angeordnet und weisen beispielsweise in einem Ausschnitt in einer Montagewand im montierten Zustand des Flitedüfters nach außen. Außerdem ist der Rahmen um den Umfang des Fiiterlüfters gesehen umlaufend durchgehend ausgebildet, beispielsweise als ein einziges Bauteil. Durch das zusätzliche Anformen von federelastischen Laschen am Rahmen des Filterlüfters sind keine Öffnungen mehr in seitlichen Außenwänden vorhanden und der Rahmen ist im Wesentlichen durchgehend um den Umfang des Filterlüfters geschlossen ausgebildet. Somit ist das Eindringen von ungefilterter Luft, beispielsweise in ein Computergehäuse, wirkungsvoll vermieden. Ebenso kann kein Wasser durch die Seitenwände in das Innere des Filters eindringen und sich somit eine Filtermatte nicht mehr mit Feuchtigkeit voll saugen.

Als nachteilig hierbei ist es jedoch anzusehen, dass in lackierten Blechausschnitten einer Montagewand eine unzureichende Rastung der Laschen im Kantenbereich der Blechausschnitte erhalten wird, was darauf zurückzuführen ist, dass der umlaufende Rand des Blechausschnittes die für eine einwandfreie Rastung erforderliche Ausbildung scharfer Kanten nicht aufweist. Durch den Lackauftrag auf das Blech des Schaltschrankes u. a. auch im Rand- bzw. Kantenbereich der Blechausschnitte entfällt die für eine einwandfreie Rastung der Laschen erforderliche Scharfkantigkeit, so dass die durch den Lackauftrag entstehenden Abrundungen im Kantenbereich keinen ausreichenden Halt der Laschen in den Rand- bzw. Kantenbereichen der Blechausschnitte gewährleisten. Hinzukommt, dass bei diesem Filterlüfter die gesamte Ecke der Schnellbefestigung auf einer schrägen Kontur klemmt, so dass es sich dabei nicht um ein direktes Verrasten handelt, was dazu führt, dass der Sitz der Rastecken in lackierten Blechen aufgrund der gerundeten Kanten im Blechausschnitt durch die aufgebrachte Farbe und somit durch fehlende scharfe Kanten unzureichend sicher war und es somit zu einem selbstständigen Lösen des Filterlüfters aus seiner Halterung im Blechausschnitt des Schaltschrankes kommen konnte.

Die EP 1 720 395 A1 schlägt nun vor, am Rahmen des Grundgehäuses des Filterlüfters jeweils Gruppen von Rastlaschen an gegenüberliegenden Seitenwänden des Rahmens vorzusehen. Jede Gruppe besteht aus einer Anzahl von gleichartig ausgebildeten Rastlaschen, wobei der Abstand zwischen dem freien Ende einer Rastlasche und dem Flansch des Filtergehäuses, der im montierten Zustand an der Montagewand anliegt, variiert. So weisen die innenliegenden Rastlaschen den größten Abstand zwischen freiem Ende und Flansch und die außen im Eckbereich, in dem zwei Seitenwände des Rahmens aneinanderstoßen, angeordneten Rastlaschen den geringsten Abstand auf. Hierdurch wird erreicht, dass auch bei verschiedenen Wandstärken der Montagewand jeweils eine der Rastlaschen den Filterlüfter fest an der Montagewand verrastet.

Die EP 0 352 113 A2 offenbart eine Vorrichtung für Gasmasken, bei der ein Gehäuse mit darin befindlichem Filter an eine Gasmaske anschließbar ist, wobei an der der Gasmaske abgewandten Seite des Behälters wiederum ein sich in einem weiteren Gehäuse befindliches Gebläse befestigbar ist. An dem dem Filtergehäuse zugewandten Randbereich des Gebläsegehäuses sind umlaufend angeordnet parallele Schlitze vorgesehen, so dass sich eine Anzahl von Rastlaschen ergibt, die aus der Gehäusewand des Gebläses herausgeschnitten sind. Mit Hilfe dieser Rastlaschen ist das Gebläsegehäuse am Filtergehäuse befestigbar.

Die US 6,189,848 B1 zeigt ein Befestigungsblech mit integralen Federclips zur Befestigung von elektronischen Komponenten, wie beispielsweise

Stromrichtern an Baugruppenträgern, wobei das Befestigungsmittel zur Reduzierung elektromagnetischer Interferenzen ausgebildet sein soll. An ein ebenes Grundblech sind bei dem Befestigungsmittel mehrere federnde Klemmzungen ausgebildet, mit denen eine elektronische Komponente an einer Wand eines Baugruppenträgers festgeklemmt werden kann, indem die Wand zwischen ebenem Grundblech und Klemmzungen eingeführt wird. Das Befestigungsmittel selbst wird mittels geeigneter Befestigungsmittel wie Schrauben am elektronischen Bauteil befestigt.

Es versteht sich, dass der Filterlüfter in an sich bekannter Weise zusätzlich mit einer Filtermatte und/oder einem Gebläse und/oder Luftleiteinrichtungen u. dgl. ausgestattet sein kann. Selbstverständlich können Lammellen, die als Luftleiteinrichtung dienen, auch schwenkbeweglich ausgebildet sein. Prinzipiell ist es möglich, dass an dem Rahmen lediglich eine einzige oder mehrere, bevorzugt wie im Folgenden beschrieben, federelastische Laschen angeordnet sind.

Der Erfindung liegt die Aufgabe zugrunde, einen Filterlüfter derart auszubilden, dass das Ansaugen von ungefilterter Luft und das Eindringen von Feuchtigkeit und Wasser in den Innenraum des Gehäuses des Filterlüfters vermieden wird und dass darüber hinaus festsitzende, jedoch lösbare Rastverbindungen auch bei unterschiedlichen Blechstärken zwischen dem Filterlüfter und dem Blechausschnitt der Montagewand z. B. eines Schaltschrankes erreicht werden.

Diese Aufgabe wird durch die im Anspruch 1 angegebenen Merkmale gelöst.

Weitere vorteilhafte Ausführungsformen und Weiterentwicklungen der Erfindung sind Gegenstand der Unteransprüche.

An der umlaufenden Wandfläche des Rahmens des Grundgehäuses sind mindestens zwei plattenförmige Zuschnitte mit federelastischen Rastzungen angeformt, die jeweils an zwei sich gegenüberliegenden Seitenwandflächen des Rahmens an den Seitenwandflächen angeformt sind.

Die plattenförmigen Zuschnitte mit den federelastischen Rastzungen sind mittig der Seitenwandflächen des Rahmens des Grundgehäuses an den Seitenwandflächen angeformt.

Bei einer weiteren bevorzugten erfindungsgemäßen Ausführungsform sind vier plattenförmige Zuschnitte mit den federelastischen Rastzungen in den Eckbereichen des Grundgehäuses an den Seitenwandflächen des Rahmens angeformt, wobei die Anordnung der plattenförmigen Zuschnitte an jeweils zwei sich gegenüberliegenden Seitenwandflächen des Rahmens des Grundgehäuses vorgesehen sind.

Erfndungswesentlich ist, dass die federelastischen Rastzungen durch schlitzförmige Einschneidungen in jedem plattenförmigen Zuschnitt ausgebildet sind.

Dabei sind die Längen der federelastischen Rastzungen eines jeden plattenförmigen Zuschnittes in Richtung zu den äußeren Kanten zweier aneinander stoßenden Seitenwandflächen des Rahmens des Grundgehäuses abnehmend ausgebildet.

Jeder plattenförmige Zuschnitt mit seinen federelastischen Rastzungen besteht bevorzugterweise aus einem Kunststoff. Auch das Grundgehäuse des Filterlüfters kann aus einem Kunststoff bestehen.

Nach einer weiteren Ausführungsform der Erfindung bestehen der Filterlüfter und die plattenförmigen Zuschnitte mit den federelastischen Rastzungen aus dem gleichen Kunststoff.

Der Vorteil, der mit dem erfindungsgemäß ausgebildeten Filterlüfter erreicht wird, besteht darin, dass die bei den bekannten Filterlüftern ausgebildeten Rastecken in ihrer Formgebung zwar unverändert geblieben sind, lediglich durch Schlitzausbildungen wurden kleine Rastzungen geschaffen, die definiert hörbar verrasten. Entsprechend der unterschiedlichen Blechstärken der Montagewände kommt die jeweils zugehörige Rastzunge zum Eingriff und wird bei dünneren Blechen mit den bereits durchgedrückten Rastzungen zusätzlich gesichert, was dadurch möglich ist, dass die Längen der Rastzungen zum äußeren Kantenbereich hin sich verkürzen. Auf diese Weise ist ein sicheres Verrasten des Filterlüfters im Ausschnitt einer Montagewand unabhängig von der Blechstärke der Montagewand oder der Dicke der auf die Montagewand aufgetragenen Lackschicht gewährleistet.

Ausführungsbeispiele sind nachstehend anhand der Zeichnungen näher erläutert. Es zeigen:
- Fig. 1: einen Filterlüfter in einem senkrechten Schnitt,
- Fig. 2: eine Ansicht von vom auf den Filterlüfter,
- Fig. 3: eine Rückansicht des Filterlüfters mit nicht erfindungsgemäßen flügelartigen Laschen zur Schnellbefestigung des Filterlüfters an einer Montagewand,
- Fig. 4: eine Ansicht von oben auf den Rahmen des Filterlüfters mit den nicht erfindungsgemäßen flügelartigen Laschen,
- Fig. 5: eine vergrößerte Ansicht eines Abschnittes des Rahmens des Filterlüfters mit einer nicht erfindungsgemäßen flügelartigen Lasche,
- Fig. 6: eine weitere Ansicht von oben auf den Rahmen des Filterlüfters mit den nicht erfindungsgemäßen flügelartigen Laschen,
- Fig. 7: eine Ansicht von oben auf den Filterlüfter mit in den Eckbereichen des Rahmens seines Grundgehäuses angeordneten erfindungsgemäßen flügelartigen Laschen mit in diesen ausgebildeten Rastzungen,
- Fig. 7A: eine vergrößerte Ansicht eines Eckbereiches des Rahmens gemäß Fig. 7 mit der flügelartigen, Rastzungen aufweisenden Lasche,
- Fig. 8: eine Seitenansicht des Filterlüfters mit in den Eckbereichen des Rahmens seines Grundgehäuses angeordneten flügelartigen Laschen mit den Rastzungen,
- Fig. 8A: eine vergrößerte Ansicht eines Eckbereiches des Rahmens gemäß Fig. 8 mit der Lasche,
- Fig. 9: eine schaubildliche Ansicht eines Eckbereiches des Filterlüfters mit der flügelartigen, Rastzungen aufweisenden Lasche,
- Fig. 10: eine schaubildliche Ansicht des in die Öffnung einer Montagewand eingesetzten Filterlüfters und
- Fig. 11: den in den Ausschnitt einer Montagewand eingesetzten Filterlüfter mit den flügelartigen Laschen im Querschnitt.

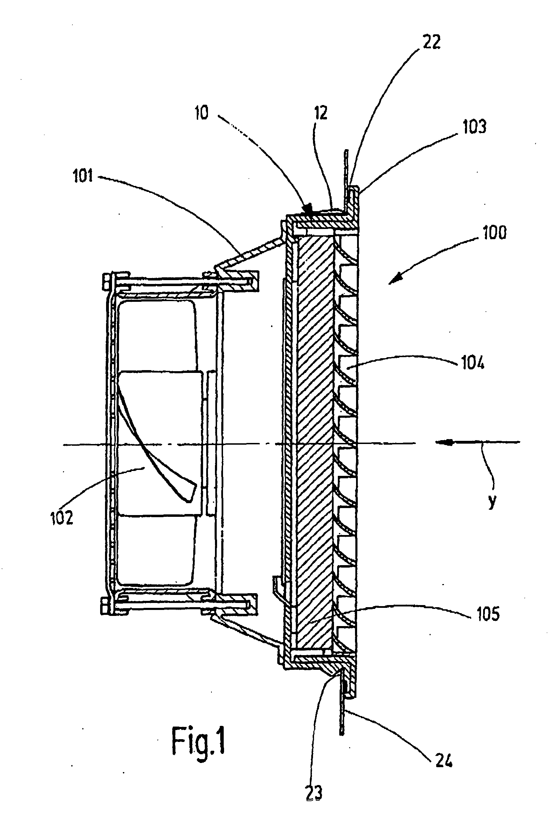

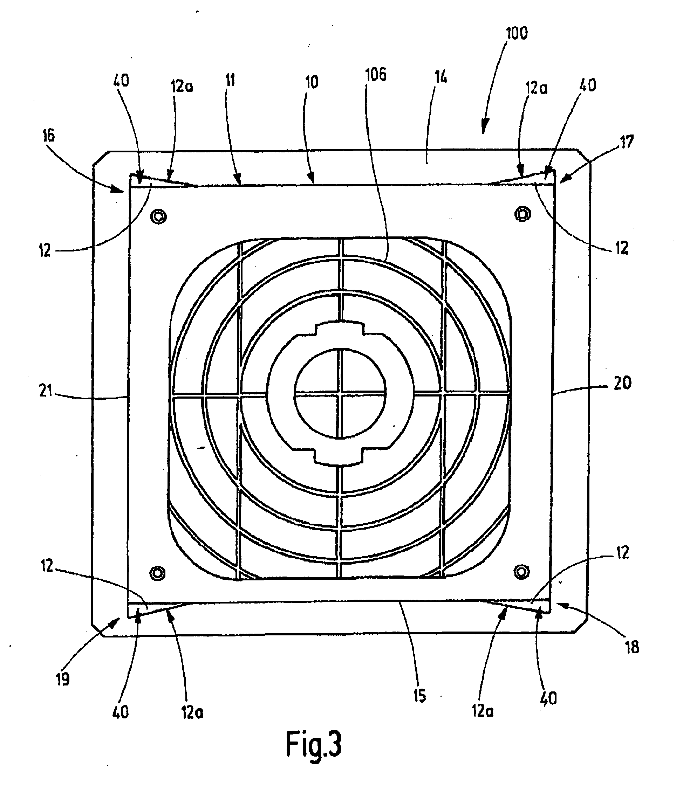

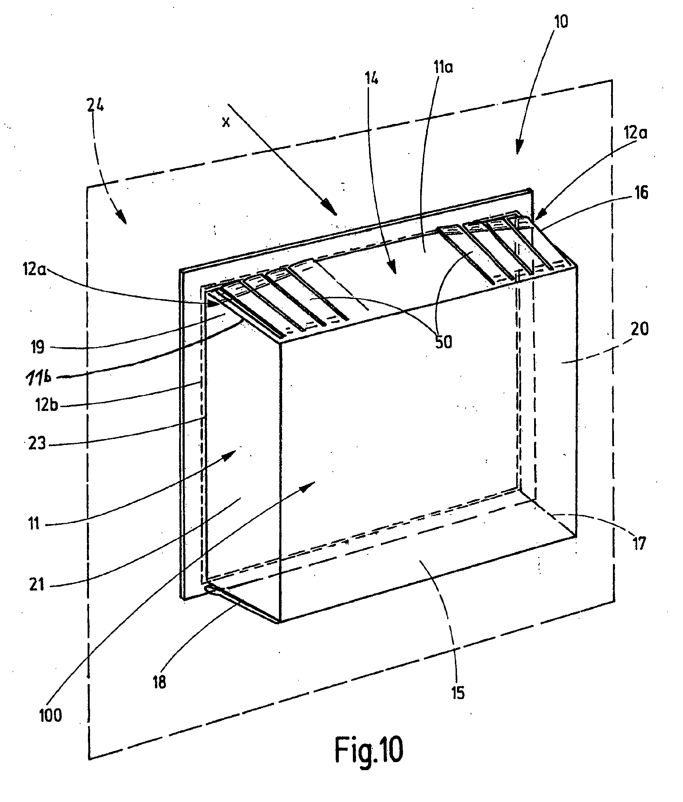

Der in den Fig. 1 bis 3 gezeigte Filterlüfter 100 besteht aus einem Grundgehäuse 10 mit einem Gebläseträger 101, der ein elektromotorisch betriebenes Gebläse 102 aufnimmt. Die offen ausgebildete Rückwand des Gebläseträgers 101 ist mittels eines Schutzgitters 106 verschlossen (Fig. 3). An das Grundgehäuse 10 ist vorzugsweise ein Rahmen 11 angeformt. Bei einem quadratischen oder rechteckigen Filterlüfter 100 besteht der Rahmen 11 aus vier Seitenwänden 14, 15, 20, 21 (Fig. 10).

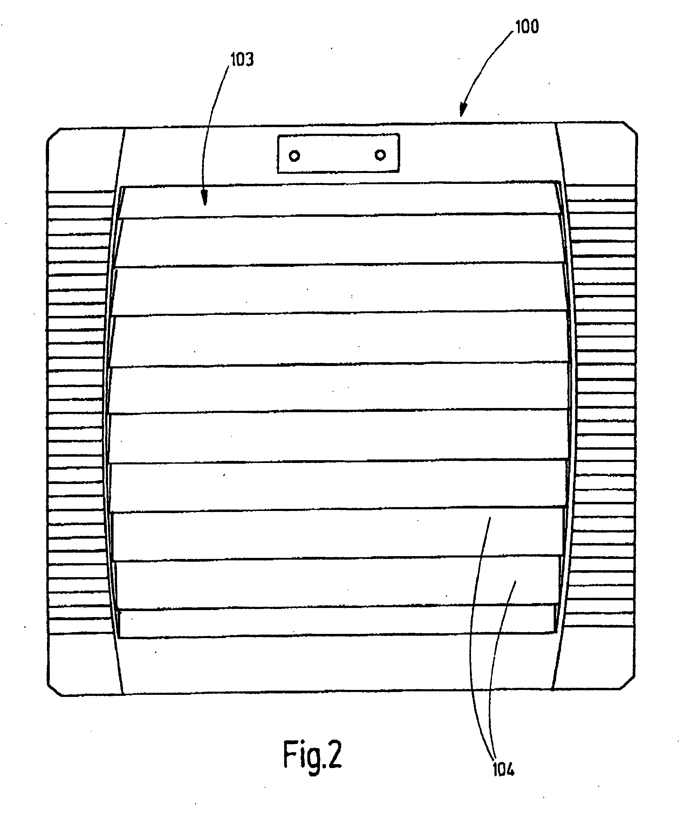

Das Grundgehäuse 10 weist vorderseitig einen Designdeckel 103 mit Luftleiteinrichtungen, beispielsweise in Form von Lamellen 104, auf (Fig. 1 und 2). Der Designdeckel 103 bzw. das Grundgehäuse 10 nimmt eine Filtermatte 105 zum Filtern der durch den Filterlüfter 100 in Pfeilrichtung Y geförderten Luft auf (Fig. 1). Der Filterlüfter 100 ist aus einem oder mehreren Kunststoff-Spritzgussteilen und/oder aus Metallteilen aufgebaut. Der Designträger 103 ist über eine umlaufende Dichtung 22 mit dem Grundgehäuse 10 bevorzugterweise lösbar verbunden, um die Filtermatte 105 austauschen zu können (Fig. 1).

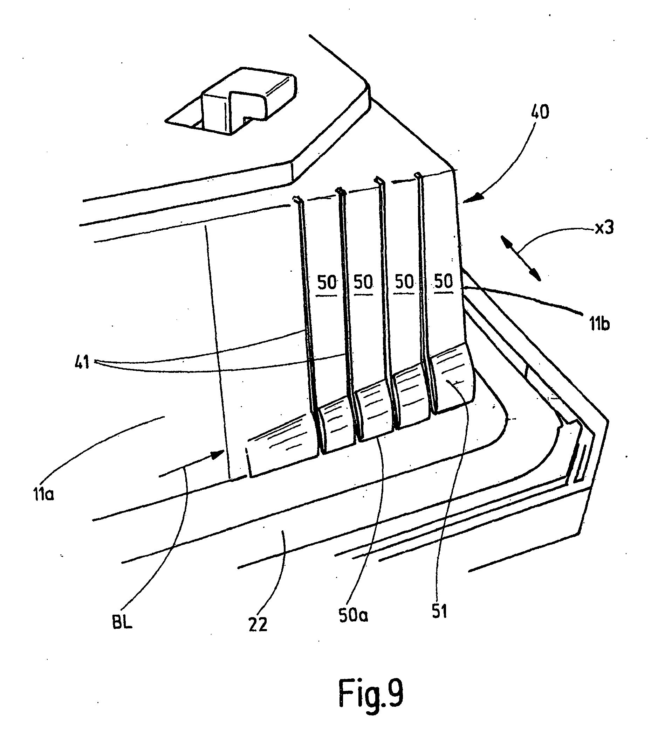

Der Filterlüfter 100 mit seinem Grundgehäuse 10 ist im eingebauten Zustand in einem Ausschnitt 23 in einer Montagewand 24, z. B. eines Schaltschrankes, angeordnet (Fig. 1). Die lösbare Befestigung bzw. Halterung des Filterlüfters 100 in dem Ausschnitt 23 der Montagewand 24 erfolgt über eine Rastverbindung mit an dem Rahmen 11 des Grundgehäuses 10 angeordneten Schnellbefestigungseinrichtungen 60, die als Rastelement 12a in Form von federelastischen Rastzungen 50 aufweisenden Laschen 12 ausgebildet sind (Fig. 9 und 10).

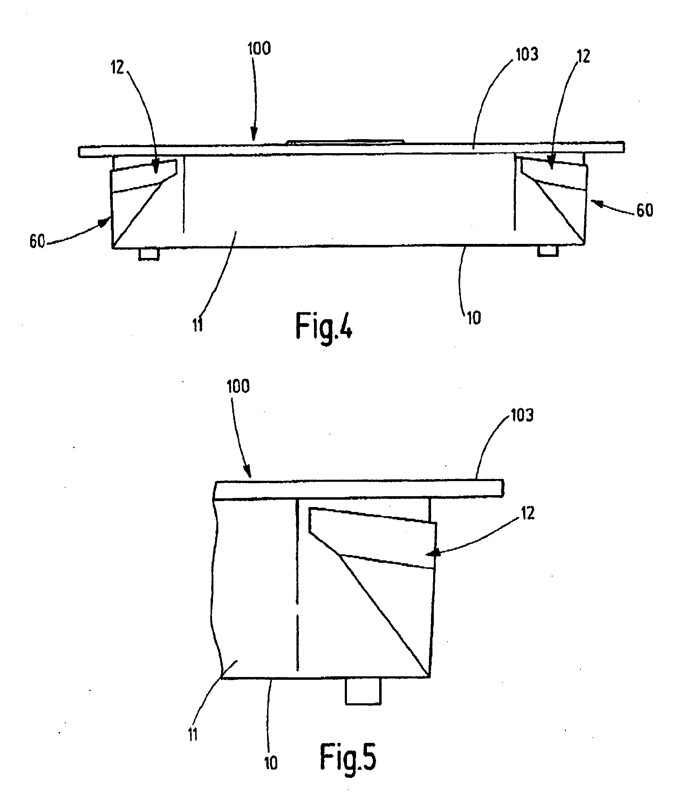

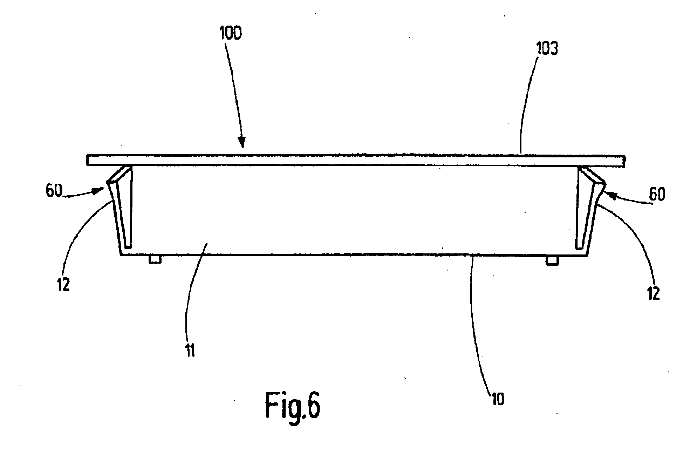

Zur lösbaren Befestigung des Filterlüfters 100 im Ausschnitt 23 der Montagewand 24 wird der Filterlüfter 100, wie durch den Pfeil X angegeben, in den Ausschnitt 23 eingeführt (Fig. 10). Dabei können die an dem Rahmen 11 angeformten, flügelartigen und federelastischen, Rastelemente (12a) bildende Laschen 12, wie durch den Doppelpfeil X3 verdeutlicht, geringfügig in Richtung zur Mitte des Ausschnitts 23 hin verbogen werden (Fig. 9). Die Laschen 12 sind einstückig mit den Seitenwänden 14, 15, 20, 21 des Rahmens 11 an diesen angeformt (Fig. 3, 4, 5, 6, 7, 7A, 8, 8A, 9 und 10).

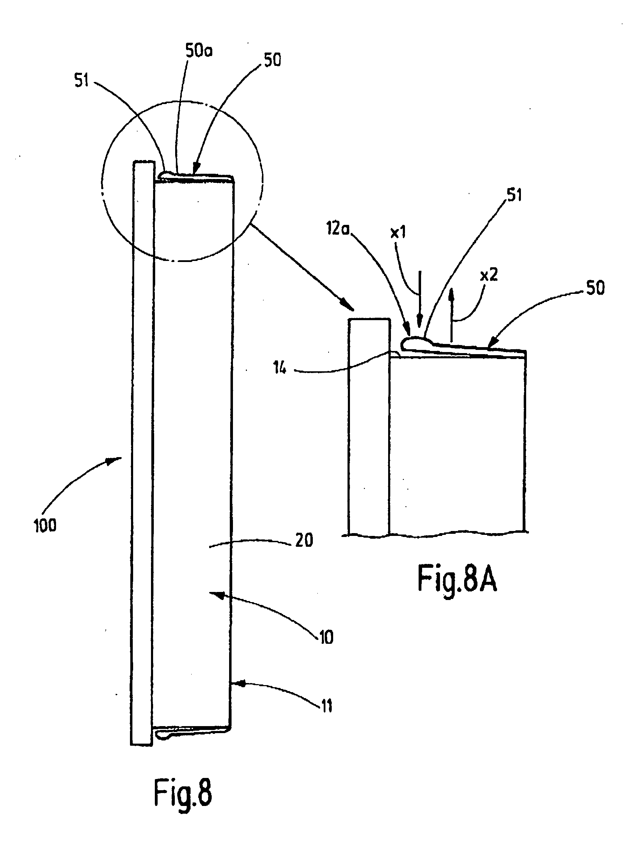

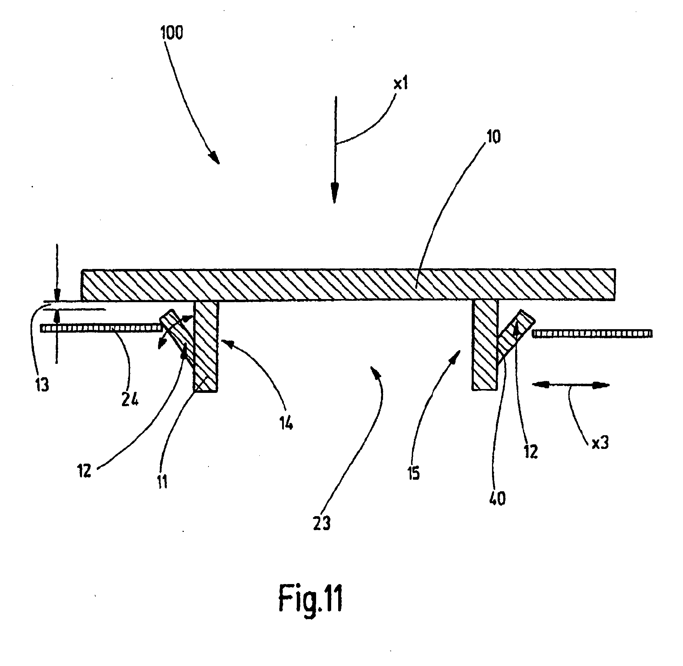

Sobald der Filterlüfter 100 weit genug in den Ausschnitt 23 der Montagewand 24 eingeschoben ist, wobei die Laschen 12 in Pfeilrichtung X1 gegen die Wandfläche der Seitenwand 14 gedrückt werden, federn die Laschen 12 in Pfeilrichtung X2 in ihre Ausgangsposition zurück und verriegeln den Filterlüfter 100 in seiner eingesetzten Position (Fig. 8 und 8A). Zum Entfernen des Filterlüfters 100 können die Laschen 12 in Pfeilrichtung X1 wieder leicht nach innen gedrückt werden (Fig. 11).

Um den Filterlüfter 100 beispielsweise an einem Metall- oder Kunststoffgehäuse eines Computers, eines Schaltschranks o. dgl. zu befestigen, ist der Abstand beziehungsweise Zwischenraum 13 zwischen einer oberen Kante 25 einer Lasche 12 und einer Montagewandanlagekante des Grundgehäuses 10 vorzugsweise in einem Bereich zwischen ein und vier Millimeter gewählt (Fig. 11).

Dabei können die Laschen 12 entweder am Rahmen 11 in den Eckbereich 16, 17, 18, 19 des Rahmens 11 angeordnet sein oder mittig an einer Seitenwand 14, 15, 20, 21. An dem Rahmen 11 können die Laschen 12 auch in sonstiger beliebiger Weise verteilt angeordnet sein. Die Laschen 12 können in an sich beliebiger weise ausgeformt sein, bevorzugt jedoch dreieckig oder rechteckig. Die Laschen 12 sind an der Wandfläche des Rahmens 11 angeformt so dass die Seitenwände 14, 15, 20, 21 des Rahmens 11 immer geschlossene Wandflächen bilden.

Die Anzahl der Laschen 12 kann beliebig gewählt sein, ebenso deren Anordnung am Rahmen 11. Neben einer Anordnung der Laschen 12 in den Eckbereichen 16, 17, 18, 19 können Laschen 12 auch in den mittigen Seitenwandbereichen des Rahmens 11 vorgesehen sein. Mindestens zwei Laschen 12 sollten an sich gegenüberliegenden Seitenwänden des Rahmens 11 vorgesehen sein. Die Laschen 12 bestehen bevorzugterweise aus dem Material des Rahmens 11, jedoch weisen die Laschen eine federelastische Ausgestaltung auf, aufgrund der die Lasche 12 nach Aufhebung eines auf die Laschen ausgeübten Druckes zurückfedern können.

Um den Filterlüfter 100 im montierten Zustand, d. h. wenn die Montagewandanlagekante beziehungsweise das Grundgehäuse 10 im Wesentlichen bündig und flächig an der Montagewand 24 anliegt, abzudichten, ist eine um den Filterlüfter 100 durchgehend umlaufende Gummidichtung 22 aus einem hierfür geeigneten Kunststoffmaterial vorgesehen. Insbesondere ist die Gummidichtung 22 in einer Nut eingeklebt, um das Eindringen von Luft und/oder Feuchtigkeit zwischen Filterlüfter 100 und Montagewand 24 zu vermeiden (Fig. 1 und 9).

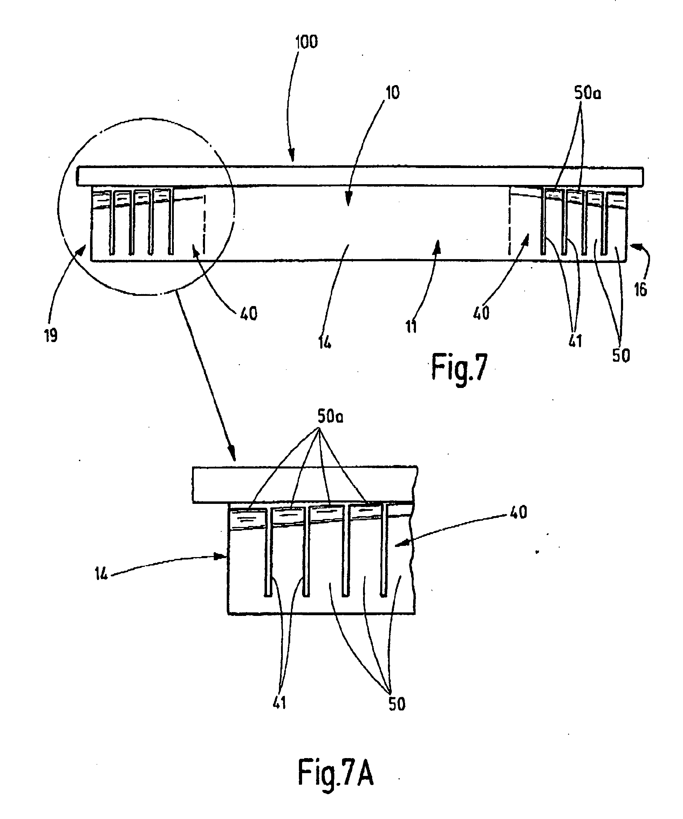

Jede an dem Rahmen 11 des Grundgehäuses 10 des Filterlüfters 100 angebrachte Lasche 12 ist als plattenförmiger Zuschnitt 40 ausgebildet, die zur Ausbildung von federelastischen Rastzungen 50 mit einer Anzahl von Schlitzen 41 versehen ist (Fig. 7, 7A, 9 und 10). Jeder plattenförmige Zuschnitt 40 ist einendseitig an der Wandfläche 11 a des Rahmens 11 angeformt. Die Anzahl der Schlitze 41 kann dabei beliebig und somit auch die Anzahl der Rastzungen 50 gewählt sein. Diese federelastischen Rastzungen 50 weisen in etwa eine der Breite der Wandfläche 11a des Rahmens 11 entsprechende Länge auf. Deren dem Designdeckel 103 zugekehrten Enden 50a der Rastzungen 50 weisen außenwandseitig nockenartige Wandverstärkungen 51 auf (8, 8A und 9). Diese nockenartigen Wandverstärkungen 51 sind mit Gleitflächen versehen, um ein müheloses Einführen der Laschen in den Ausschnitt 23 der Montagewand 24 zu gewährleisten.

Die Längen der federelastischen Rastzungen 50 eines jeden plattenförmigen Zuschnittes 40 sind in Richtung zu den äußeren Kanten 11 b zweier aneinander stoßenden Seitenwänden 14, 15, 20, 21 des Rahmens 11 abnehmend ausgebildet (Fig. 9). Bevorzugterweise sind die freien Enden 50a geringfügig nach außen abgebogen.

Entsprechend Fig. 9 sind die Enden 50a der Rastzungen leicht abgebogen, wobei die Biegelinie BL schräg verlaufend ist, so dass sich abgebogene Endabschnitte unterschiedlicher Länge ergeben.

Die plattenförmigen Zuschnitte 40 mit ihren Rastzungen 50 bestehen bevorzugterweise aus einem Kunststoff, der die federelastischen Eigenschaften der Rastzungen 50 bewirkt.

### Bezugszeichenliste

- 100: Filterlüfter
- 101: Gebläseträger
- 102: Gebläse
- 103: Designdeckel
- 104: Lamellen
- 105: Filtermatte
- 106: Schutzgitter

- 10: Grundgehäuse
- 11: Rahmen
- 11a: Wandfläche
- 11b: Kante
- 12: Laschen
- 12a: Rastelemente
- 13: Zwischenraum
- 14: Seitenwand
- 15: Seitenwand
- 16: Eckbereich
- 17: Eckbereich
- 18: Eckbereich
- 19: Eckbereich
- 20: Seitenwand
- 21: Seitenwand
- 22: Dichtung
- 23: Ausschnitt
- 24: Montagewand
- 25: obere Kante

- 40: plattenförmiger Zuschnitt
- 41: Schlitze

- 50: Rastzungen
- 50a: Enden
- 51: Wandverstärkungen

- 60: Schnellbefestigung

- Y: Pfeilrichtung
- X: Pfeilrichtung
- X1: Pfeilrichtung
- X2: Pfeilrichtung
- X3: Pfeilrichtung

- BL: Biegelinie

## Patentansprüche

1. Filterlüfter (100) mit einem Grundgehäuse (10) mit einem Rahmen (11), der mit Schnellbefestigungseinrichtungen (60) in Form von federelastischen, bevorzugterweise flügelartigen Laschen (12) zur Montage des Filterlüfters (100) in einem Wandausschnitt einer Montagewand versehen ist, wobei der Rahmen (11) um seinen Umfang durchgehend umlaufend geschlossen ausgebildet ist und die Laschen (12) einstückig mit Seitenwänden (14, 15, 20, 21) des Rahmens (11) an diesen angeformt sind, wobei die Laschen (12) als plattenförmige Zuschnitte (40) ausgebildet sind, die jeweils einendseitig an eine Wandfläche (11a) des Rahmens (11) angeformt sind, **dadurch gekennzeichnet, dass** zur Ausbildung von federelastischen Rastzungen (50) jeder plattenförmige Zuschnitt (40) mit einer Anzahl von Schlitzen (41) versehen ist, und dass die Längen der federelastischen Rastzungen (50) eines jeden plattenförmigen Zuschnittes (40) in Richtung zu den äußeren Kanten (11b) zweier aneinander stoßender Seitenwände (14, 15; 20, 21) des Rahmens (11) des Grundgehäuses (10) abnehmend sind.

2. Filterlüfter (100) nach Anspruch 1,
**dadurch gekennzeichnet**,
dass an einer Oberseite (14) und/oder einer Unterseite (15) eines quadratischen oder rechteckigen Filterlüfters (100) jeweils an einem Eckbereich (16, 17, 18, 19) eine Lasche (12) angeordnet ist.

3. Filterlüfter nach einem der Ansprüche 1 oder 2,
**dadurch gekennzeichnet**,
dass an einer oder mehreren Seitenwänden (14, 15, 20; 21) des Rahmens (11) jeweils eine Lasche (12) angeordnet ist.

4. Filterlüfter nach einem der Ansprüche 1 bis 3,
**dadurch gekennzeichnet**,
dass mindestens an jeweils zwei sich gegenüberliegenden Seitenwänden des Rahmens (11) mindestens eine Lasche (12) vorgesehen ist.

5. Filterlüfter nach einem der Ansprüche 1 bis 4,
**dadurch gekennzeichnet**,
dass die Laschen (12) dreieckig und/oder rechteckig ausgeformt sind.

6. Filterlüfter (100) nach einem der Ansprüche 1 bis 5,
**dadurch gekennzeichnet**,
dass an der umlaufenden Wandfläche (11a) des Rahmens (11) des Grundgehäuses (10) mindestens zwei plattenförmige Zuschnitte (40) mit federelastischen Rastzungen (50) angeformt sind, die jeweils an zwei sich gegenüberliegenden Seitenwänden (14, 15; 20, 21) des Rahmens (11) an den Seitenwandflächen (11a) angeformt sind.

7. Filterlüfter (100) nach einem der Ansprüche 1 bis 6,
**dadurch gekennzeichnet**,
dass die plattenförmigen Zuschnitte (40) mit den federelastischen Rastzungen (50) mittig der Seitenwände (14, 15; 20, 21) des Rahmens (11) des Grundgehäuses (10) an den Seitenwandflächen angeformt sind.

8. Filterlüfter (100) nach einem der Ansprüche 1 bis 7,
**dadurch gekennzeichnet**,
dass vier plattenförmige Zuschnitte (40) mit den federelastischen Rastzungen (50) in den Eckbereichen (16, 17, 18, 19) des Grundgehäuses (10) an den Seitenwandflächen (14, 15; 20, 21) des Rahmens (11) angeformt sind, wobei die Anordnung der plattenförmigen Zuschnitte (50) an jeweils zwei sich gegenüberliegenden Seitenwandflächen (14, 15; 20, 21) des Rahmens (11) des Grundgehäuses (10) vorgesehen sind.

9. Filterlüfter (100) nach einem der Ansprüche 1 bis 8,
**dadurch gekennzeichnet**,
dass die freien Enden (50a) der Rastzungen (50) bevorzugterweise geringfügig nach außen abgebogen sind.

10. Filterlüfter (100) nach einem der Ansprüche 1 bis 9,
**dadurch gekennzeichnet**,
dass jeder plattenförmige Zuschnitt (40) mit seinen federelastischen Rastzungen (50) aus einem Kunststoff besteht.

11. Filterlüfter (100) nach einem der Ansprüche 1 bis 10,
**dadurch gekennzeichnet**,
dass das Grundgehäuse (10) mit seinem Rahmen (11) des Filterlüfters (100) aus einem Kunststoff besteht.

12. Filterlüfter (100) nach einem der Ansprüche 1 bis 11,
**dadurch gekennzeichnet**,
dass das Grundgehäuse (10) des Filterlüfters (100) und die plattenförmigen Zuschnitte (40) mit den federelastischen Rastzungen (50) aus dem gleichen Kunststoff bestehen.

13. Filterlüfter (100) nach einem der Ansprüche 1 bis 12,
**dadurch gekennzeichnet**,
dass der Montagewandanlagekante ein Dichtungsmittel zugeordnet ist, insbesondere eine in eine Nut eingesetzte Gummidichtung (22).

## Claims

1. A filter fan (100) comprising a basic housing (10) comprising a frame (11), which is provided with rapid fastening devices (60) in the form of spring-elastic, preferably wing-type clips (12) for mounting the filter fan (100) in a wall section of a mounting wall, wherein the frame (11) is embodied so as to be closed circumferentially continuously about its circumference and the clips (12) are integrally moulded to said frame in one piece with side walls (14, 15; 20, 21) thereof, wherein the clips (12) are configured as plate-shaped cuts (40), which are in each case integrally moulded to a wall surface (11a) of the frame (11) on one end, **characterized in that** each plate-shaped cut (40) is provided with a number of slits (41) for configuration of spring-elastic snap-in pins (50), and that the lengths of the spring-elastic snap-in pins (50) of each plate-shaped cut (40) decrease in the direction towards the outer edges (11b) of two side walls (14, 15; 20, 21) of the frame (11) of the basic housing (10), which abut against one another.

2. The filter fan (100) according to claim 1,
**characterized in**
that a clip (12) is arranged at an upper side (14) and/or a bottom side (15) of a square or rectangular filter fan (100), in each case at a corner area (16, 17, 18, 19).

3. The filter fan according to one of claims 1 or 2,
**characterized in**
that a clip (12) is in each case arranged at one or a plurality of side walls (14, 15, 20; 21) of the frame (11).

4. The filter fan according to one of claims 1 to 3,
**characterized in**
that provision is in each case made at two opposite side walls of the frame (11) for at least one clip (12).

5. The filter fan according to one of claims 1 to 4,
**characterized in**
that the clips (12) are shaped so as to be triangular and/or rectangular.

6. The filter fan (100) according to one of claims 1 to 5,
**characterized in**
that at least two plate-shaped cuts (40) comprising spring-elastic snap-in pins (50), which are in each case integrally moulded to the side wall surfaces (11a) at two opposite side walls (14, 15; 20, 21) of the frame (11), are integrally moulded to the circumferential wall surface (11a) of the frame (11) of the basic housing (10).

7. The filter fan (100) according to one of claims 1 to 6,
**characterized in**
that the plate-shaped cuts (40) comprising the spring-elastic snap-in pins (50) are integrally moulded to the side wall surfaces in the centre of the side walls (14, 15; 20, 21) of the frame (11) of the basic housing (10).

8. The filter fan (100) according to one of claims 1 to 7,
**characterized in**
that four plate-shaped cuts (40) comprising the spring-elastic snap-in pins (50) are integrally moulded to the side wall surfaces (14, 15; 20, 21) of the frame (11) in the corner areas (16, 17, 18, 19) of the basic housing (10), wherein the arrangement of the plate-shaped cuts (50) is in each case provided at two opposite side wall surfaces (14, 15; 20, 21) of the frame (11) of the basic housing (10).

9. The filter fan (100) according to one of claims 1 to 8,
**characterized in**
that the free ends (50a) of the snap-in pins (50) are preferably bent slightly outward.

10. The filter fan (100) according to one of claims 1 to 9,
**characterized in**
that each plate-shaped cut (40) comprising its spring-elastic snap-in pins (50) consists of a plastic.

11. The filter fan (100) according to one of claims 1 to 10,
**characterized in**
that the basic housing (10) comprising its frame (11) of the filter fan (100) consists of a plastic.

12. The filter fan (100) according to one of claims 1 to 11,
**characterized in**
that the basic housing (10) of the filter fan (100) and the plate-shaped cuts (40) comprising the spring-elastic snap-in pins (50) consist of the same plastic.

13. The filter fan (100) according to one of claims 1 to 12,
**characterized in**
that a sealing means, in particular a rubber seal (22), which is inserted into a groove, is associated to the mounting wall contact edge.

## Revendications

1. Ventilateur à filtre (100) avec un corps de base (10) avec un cadre (11) qui est muni de dispositifs de fixation rapide (60) sous forme de pattes (12) résilientes, de préférence du type ailettes pour le montage du ventilateur à filtre (100) dans une découpe de cloison d'une cloison de montage, le cadre (11) étant conçu en étant fermé en continu tout autour de sa périphérie et les pattes (12) étant rapportées sur le cadre, en monobloc avec parois latérales de celui-ci, les pattes (12) étant conçues en tant que pièces découpées (40) en forme de plaquettes qui sont chacune rapportée du côté d'une extrémité sur une surface de paroi (11a) du cadre (11), **caractérisé en ce que** pour créer des languettes d'enclenchement (50) résilientes, chaque pièce découpée (40) en forme de plaquette est munie d'un nombre d'encoches (41) et **en ce que** les longueurs des languettes d'enclenchement (50) résilientes de chaque pièce découpée (40) en forme de plaquette sont décroissantes en direction des arêtes (11b) extérieures de deux parois latérales (14, 15 ; 20, 21) jointives du cadre (11) du corps de base (10).

2. Ventilateur à filtre (100) selon la revendication 1,
**caractérisé en ce que**
sur une face supérieure (14) et/ou sur une face inférieure (15) d'un ventilateur à filtre (100) quadratique ou rectangulaire, une patte (12) est placée chaque fois dans une zone angulaire (16, 17, 18, 19).

3. Ventilateur à filtre selon l'une quelconque des revendications 1 ou 2,
**caractérisé en ce que**
sur une ou sur plusieurs paroi latérales (14, 15, 20; 21) du cadre (11) est chaque fois placée une patte (12).

4. Ventilateur à filtre selon l'une quelconque des revendications 1 à 3,
**caractérisé en ce qu'**
au moins sur chaque fois deux parois latérales opposées du cadre (11) est prévue au moins une patte (12).

5. Ventilateur à filtre selon l'une quelconque des revendications 1 à 4,
**caractérisé en ce que**
les pattes (12) sont façonnées en étant triangulaires et/ou rectangulaires.

6. Ventilateur à filtre (100) selon l'une quelconque des revendications 1 à 5,
**caractérisé en ce que**
sur la surface de paroi (11a) périphérique du cadre (11) du corps de base (10) sont rapportés au moins deux pièces découpées (40) en forme de plaquettes avec des languettes d'enclenchement (50) résilientes, qui sont rapportées sur les surfaces de parois latérales (11a), chaque fois sur deux parois latérales (14, 15 ; 20, 21) opposées du cadre (11).

7. Ventilateur à filtre (100) selon l'une quelconque des revendications 1 à 6,
**caractérisé en ce que**
les pièces découpées (40) en forme de plaquettes avec les languettes d'enclenchement (50) résilientes sont rapportées sur les surfaces de parois latérales, au centre des parois latérales (14, 15 ; 20, 21) du cadre (11) du corps de base (10).

8. Ventilateur à filtre (100) selon l'une quelconque des revendications 1 à 7,
**caractérisé en ce que**
quatre pièces découpées (40) avec les languettes d'enclenchement (50) résilientes sont rapportées dans les zones angulaires (16, 17, 18, 19) du corps de base (10), sur les surfaces de parois latérales (14, 15 ; 20, 21) du cadre (11), la disposition des pièces découpées (50) en forme de plaquettes étant prévue chaque fois sur deux surfaces de parois latérales (14, 15 ; 20, 21) opposées du cadre (11) du corps de base (10).

9. Ventilateur à filtre (100) selon l'une quelconque des revendications 1 à 8,
**caractérisé en ce que**
de manière la plus préférentielle, les extrémités (50a) libres des languettes d'enclenchement (50) sont légèrement recourbées vers l'extérieur.

10. Ventilateur à filtre (100) selon l'une quelconque des revendications 1 à 9,
**caractérisé en ce que**
chaque pièce découpée (40) en forme de plaquette avec ses languettes d'enclenchement (50) résilientes est constituée en une matière plastique.

11. Ventilateur à filtre (100) selon l'une quelconque des revendications 1 à 10,
**caractérisé en ce que**
le corps de base (10) avec son cadre (11) du ventilateur à filtre (100) est constitué en une matière plastique.

12. Ventilateur à filtre (100) selon l'une quelconque des revendications 1 à 11,
**caractérisé en ce que**
le corps de base (10) du ventilateur à filtre (100) et les pièces découpées (40) en forme de plaquettes avec les languettes d'enclenchement (50) résilientes sont constitués de la même matière plastique.

13. Ventilateur à filtre (100) selon l'une quelconque des revendications 1 à 12,
**caractérisé en ce qu'**
à l'arête d'appui de la paroi de montage est associé un moyen d'étanchéité, notamment un joint en caoutchouc (22) inséré dans une rainure.
